# EUROPEAN PATENT APPLICATION

(11) **EP 4 618 147 A1**
(43) Date of publication of application: **17.09.2025**
(21) Application number: 23899591.4
(22) Date of filing: 12.10.2023
(51) Int. Cl.: H01L 23/538, H01L 23/544, H01L 21/768

(54) **CHIP, MANUFACTURING METHOD THEREFOR, MULTI-CHIP STACKED PACKAGE, AND ELECTRONIC DEVICE**

(30) Priority: 08.12.2022 CN 202211571280
(71) Applicant: Huawei Technologies Co., Ltd., Shenzhen, Guangdong 518129 (CN)
(72) Inventor: LIANG, Rui, Shenzhen, Guangdong 518129 (CN); YANG, Chuncheng, Shenzhen, Guangdong 518129 (CN); LIU, Shuguang, Shenzhen, Guangdong 518129 (CN); JING, Weiliang, Shenzhen, Guangdong 518129 (CN); ZHANG, Shiwei, Shenzhen, Guangdong 518129 (CN)
(74) Representative: Goddar, Heinz J.
(86) International application number: PCT/CN2023/124344
(87) International publication number: WO 2024/120010

(57) **Abstract**

This application provides a chip, a chip fabricating method, a multi-chip stacking package, and an electronic device, and relates to the field of chip technologies, so that problems caused by probe marks generated during chip probing can be resolved. The chip in this application includes a metal connection pad, a plurality of first connection vias, a plurality of second connection vias, a first metal wire, a medium filling structure, and a first medium layer. The metal connection pad is electrically connected to the first metal wire through the plurality of first connection vias. The medium filling structure and the metal connection pad are disposed at a same layer. The plurality of second connection vias are located between the medium filling structure and the first metal wire, and are electrically connected to the first metal wire. The first medium layer covers the metal connection pad, the first medium layer has a window area at a position corresponding to the medium filling structure, and the window area is filled with a dielectric material. For the chip, during chip probing, a metal probing pad is disposed at the position of the medium filling structure, so that chip probing and 3D interconnection can be respectively implemented through the metal probing pad and the metal connection pad.

## Description

This application claims priority to Chinese Patent Application No. 202211571280.2, filed with the China National Intellectual Property Administration on December 8, 2022 and entitled "CHIP, CHIP FABRICATING METHOD, MULTI-CHIP STACKING PACKAGE, AND ELECTRONIC DEVICE", which is incorporated herein by reference in its entirety.

### TECHNICAL FIELD

This application relates to the field of chip technologies, and in particular, to a chip, a chip fabricating method, a multi-chip stacking package, and an electronic device.

### BACKGROUND

To improve a yield of a multi-chip stacking package, before chip stacking, a chip (good die) needs to be detected and identified, that is, chip probing (chip probe, CP) needs to be performed, to determine whether the chip is qualified. In particular, in wafer-to-wafer (wafer-to-wafer, W2W) stacking, a quantity of qualified chips in an entire wafer is an important parameter for determining whether the wafer can be used for stacking, and is also an effective solution for resolving a problem that a yield after W2W stacking is low.

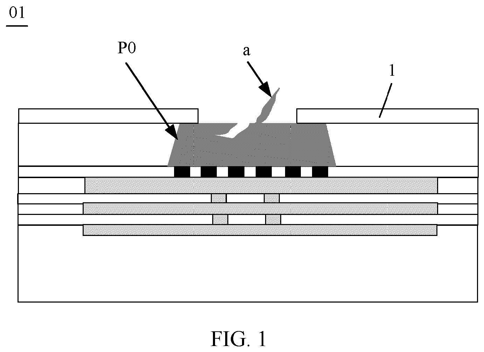

As shown in FIG. 1, in a conventional technology, a metal connection pad (pad) P0 is disposed in a top metal (top metal) of a chip 01. Before chip stacking, chip probing is performed through the metal connection pad P0. After chip probing is completed, the metal connection pad P0 implements 3D (3-dimension, three-dimensional) interconnection with another stacked chip through a connection structure. In other words, the same metal connection pad P0 is used in existing chips to complete probing and 3D interconnection.

However, with reference to FIG. 1, when probing is performed on the chip 01, a passivation layer 1 (passivation) on the metal connection pad P0 needs to be revealed, and a probe is in contact with the metal connection pad P0 for probing. A probe pressure and a quantity of times during probing cause irreversible damage to the metal connection pad P0, and consequently an indentation is formed. After probing is completed, in a process of lifting the probe, a metal in the metal connection pad P0 may be lifted. As a result, the metal connection pad P0 has a probe mark a to raise, with a height about 1.5 µm. Therefore, before chip stacking, the probe mark a needs to be processed. Currently, two manners are mainly adopted to process the probe mark: (1) A medium layer is used to bury the raised probe mark a. (2) The raised probe mark a is removed through etching. However, in the manner of burying the probe mark a by using the medium layer, it needs to be ensured that a thickness of the medium layer is greater than the height of the probe mark a. If the thickness of the medium layer is excessively large, it is inconducive to stacking of a plurality of layers of chips, and further causes a problem such as heat dissipation of the chips. In the manner of removing the probe mark a through etching, a problem of over-etching the metal connection pad P0 occurs. For example, the metal connection pad P0 is completely removed, and an electrical connection is lost, causing damage to electrical performance of the chip.

### SUMMARY

This application provides a chip, a chip fabricating method, a multi-chip stacking package, and an electronic device, so that problems caused by probe marks generated during chip probing can be resolved.

This application provides a chip. The chip includes a metal connection pad, a plurality of first connection vias, a plurality of second connection vias, a first metal wire, a medium filling structure, and a first medium layer. The metal connection pad is electrically connected to the first metal wire through the plurality of first connection vias. The medium filling structure and the metal connection pad are disposed at a same layer. The plurality of second connection vias are located between the medium filling structure and the first metal wire, and are electrically connected to the first metal wire. The first medium layer covers the metal connection pad, the first medium layer has a window area at a position corresponding to the medium filling structure, and the window area is filled with a dielectric material. During chip probing, a metal probing pad is disposed at the position of the medium filling structure. The metal probing pad is electrically connected to the first metal wire through the plurality of second connection vias. In other words, an equivalent electrical connection path can be formed between the metal probing pad and the metal connection pad, so that chip probing is separately performed through the metal probing pad, and 3D interconnection of the chip is implemented through the metal connection pad. After chip probing is completed, a probe mark on the metal probing pad is directly removed, and a removal area is filled with a dielectric material to form the medium filling structure. In other words, in the chip provided in this embodiment of this application, a separately disposed chip probing path does not affect an interconnection path. This ensures that a signal or a power supply on the interconnection path is not affected, and further avoids problems caused by probe marks generated during chip probing, for example, damage to electrical performance, poor heat dissipation, a limited quantity of stacked layers, and other problems.

In some possible implementations, a first metal material remains around the medium filling structure. Before the medium filling structure is formed, in a process of removing the probe mark on a surface of the metal probing pad, only a part of the metal probing pad may be removed, and therefore, a part of the metal material remains around the medium filling structure.

In some possible implementations, there is a void in an interior of and/or at an edge of the medium filling structure. To be specific, the void may be formed in the interior of the medium filling structure; or the void may be formed at the edge of the medium filling structure, that is, the void is around the edge of the medium filling structure; or the void may be formed at both the edge of and in the interior of the medium filling structure.

In some possible implementations, the medium filling structure includes one or more of SiO₂, SiN, SiON, SiOC, and a-Si.

In some possible implementations, the first metal material includes one or more of Al, Cu, W, SnCu, and AlCu.

In some possible implementations, the first metal material is the same as a material for forming the metal connection pad.

An embodiment of this application further provides a multi-chip stacking package, including a first chip and a second chip that are disposed in a stacked manner. The first chip uses the chip provided in any one of the foregoing possible implementations. The first chip is electrically connected to the second chip through the metal connection pad, and the medium filling structure is isolated from the second chip through a medium layer.

In some possible implementations, the metal connection pad is connected to the second chip through a first connection structure. The first connection structure includes one or more of a hybrid bonding structure, a redistribution layer, an under bump metallization structure, a fusion bonding structure, and a through silicon via.

An embodiment of this application further provides a chip fabricating method. The fabricating method includes: forming a first metal wire on a substrate, and forming a plurality of first connection vias and a plurality of second connection vias on the first metal wire; forming a metal connection pad and a metal probing pad, where the metal connection pad is connected to the first metal wire through the plurality of first connection vias, and the metal probing pad is connected to the first metal wire through the plurality of second connection vias; forming a passivation layer that covers the metal connection pad and the metal probing pad, and providing a first window at a position that is at the passivation layer and that is on the metal probing pad to expose the metal probing pad; and after completing chip probing through the exposed metal probing pad, removing a part or all of the metal probing pad, and filling a removal area with a medium material.

An embodiment of this application further provides an electronic device. The electronic device includes a circuit board and the multi-chip stacking package provided in any one of the foregoing possible implementations. The multi-chip stacking package is electrically connected to the circuit board.

### BRIEF DESCRIPTION OF DRAWINGS

FIG. 1 is a diagram of a structure of a chip according to a conventional technology;
FIG. 2 is a diagram of a structure of a multi-chip stacking package according to an embodiment of this application;
FIG. 3 is a diagram of a structure of a multi-chip stacking package according to an embodiment of this application;
FIG. 4 is a diagram of a structure of a chip according to an embodiment of this application;
FIG. 5 is a diagram of a structure of a chip according to an embodiment of this application;
FIG. 6 is a diagram of a chip after probing according to an embodiment of this application;
FIG. 7 is a diagram of a structure of a chip according to an embodiment of this application;
FIG. 8 is a flowchart of a chip fabricating method according to an embodiment of this application;
FIG. 9 is a diagram of a chip fabricating process according to an embodiment of this application; and
FIG. 10 is a diagram of parallel distribution of a connection pad and a probing pad in a chip according to an embodiment of this application.

### DESCRIPTION OF EMBODIMENTS

To make objectives, technical solutions, and advantages of this application clearer, the following clearly and completely describes technical solutions in this application with reference to the accompanying drawings in this application. It is clear that the described embodiments are merely some rather than all of embodiments of this application. All other embodiments obtained by a person of ordinary skill in the art based on embodiments of this application without creative efforts shall fall within the protection scope of this application.

In the specification, embodiments, claims, and accompanying drawings of this application, the terms "first", "second", and the like are merely intended for distinguishing and description, and shall not be understood as indicating or implying relative importance, or indicating or implying a sequence. "At least one piece (item)" means one or more, and "a plurality of" means two or more. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" generally indicates an "or" relationship between the associated objects. "Installation", "connection", "connecting", or the like should be understood in a broad sense. For example, it may be a fixed connection, a detachable connection, or an integrated connection; may be a direct connection; or may be an indirect connection through an intermediate medium; or may be internal communication between two elements; or may be an electrical connection between two elements. In addition, the terms "include", "have", and any variant thereof are intended to cover non-exclusive inclusion, for example, include a series of steps or units. A method, system, product, or device is not necessarily limited to those steps or units expressly listed, but may include other steps or units not expressly listed or inherent to such a process, method, product, or device. "On", "below", "left", "right", and the like are used only relative to orientations of components in the accompanying drawings. These directional terms are relative concepts, are used for relative descriptions and clarifications, and may change accordingly as positions at which the components in the accompanying drawings are placed change.

An embodiment of this application provides an electronic device. The electronic device includes a printed circuit board (printed circuit board, PCB, which may also be referred to as a circuit board) and a multi-chip stacking package that is disposed on the printed circuit board. The multi-chip stacking package is electrically connected to the circuit board.

Certainly, in some possible implementations, the electronic device may further include an interposer (interposer), and the multi-chip stacking package is electrically connected to the circuit board through the interposer. This is not limited in this application. In practice, the electronic device may be specifically disposed based on an application scenario and according to a related requirement.

A disposing form of the electronic device is not limited in this application. For example, the electronic device may be an electronic product such as a mobile phone, a tablet computer, a notebook computer, a vehicle-mounted computer, a smartwatch, or a smart band.

A disposing form of the multi-chip stacking package is not limited in this application. For example, the multi-chip stacking package may be a device such as a storage apparatus or a processor.

The following briefly describes the multi-chip stacking package provided in embodiments of this application.

First, it should be noted that the multi-chip stacking package in this application may be wafer-to-wafer (wafer-to-wafer, W2W) stacking, chip-to-wafer (chip-to-wafer, C2W) stacking, or chip-to-chip (chip-to-chip, C2C) stacking. This is not limited in this application.

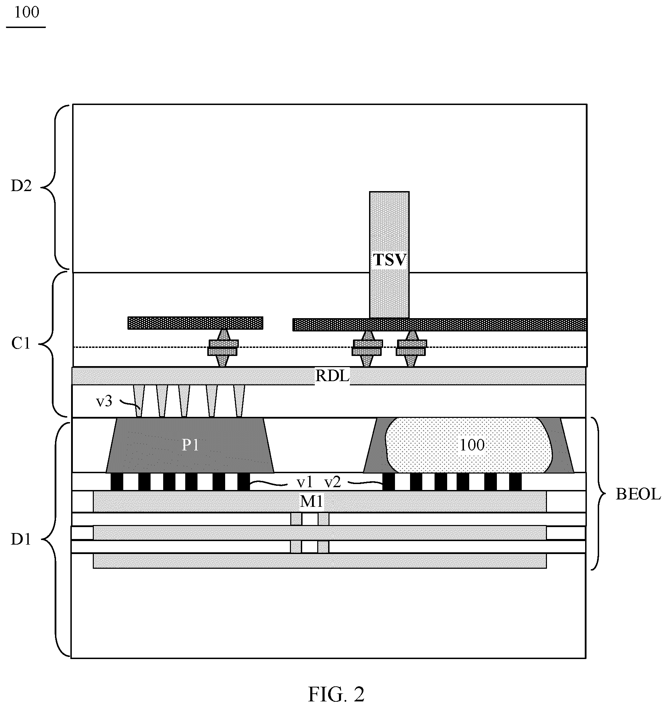

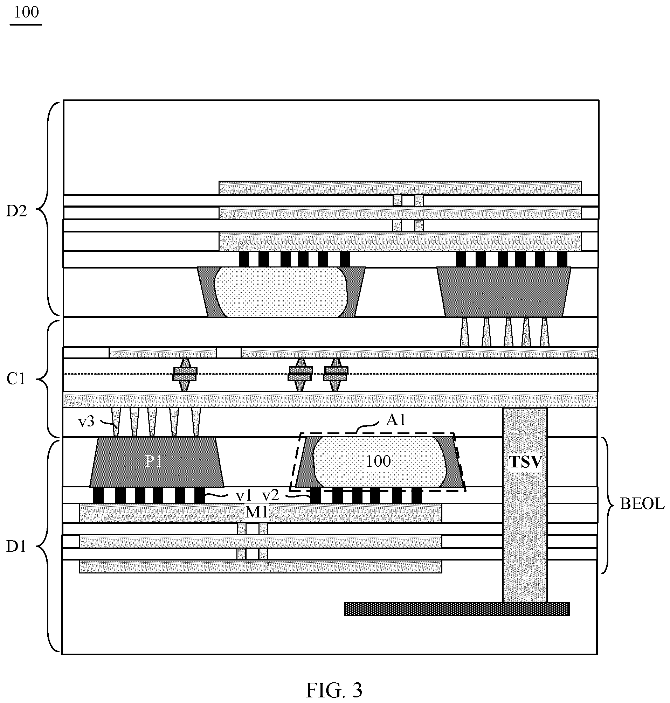

With reference to FIG. 2 and FIG. 3, an embodiment of this application provides a multi-chip stacking package 100. The multi-chip stacking package 100 includes a plurality of chips disposed in a stacked manner, and the plurality of chips include a first chip D1 and a second chip D2. Certainly, the multi-chip stacking package 100 may further include a third chip, a fourth chip, and the like that are disposed in a stacked manner. A quantity of chips disposed in a stacked manner in the multi-chip stacking package is not limited in this application.

A stacked manner between chips is not limited in this application. For example, with reference to FIG. 2, the first chip D1 and the second chip D2 may be stacked in an F2B (face to back, face to back) manner. That is, an active surface of the first chip D1 and a passive surface of the second chip D2 are disposed opposite to each other. In addition, the first chip D1 and the second chip D2 are electrically connected through a 3D interconnection structure (which may also be referred to as a first connection structure). For another example, as shown in FIG. 3, the first chip D1 and the second chip D2 may be stacked in an F2F (face to face, face to face) manner. That is, an active surface of the first chip D1 and an active surface of the second chip D2 are disposed opposite to each other. In addition, the first chip D1 and the second chip D2 are electrically connected through a 3D interconnection structure.

A specific disposing form of the 3D interconnection structure (which may also be referred to as the first connection structure) used between the first chip D1 and the second chip D2 is not limited in this application. In practice, the 3D interconnection structure may be disposed based on an application scenario. For example, in some possible implementations, the 3D interconnection structure used between the first chip D1 and the second chip D2 may include one or more of a hybrid bonding (hybrid bonding, HB) structure, a redistribution layer (redistribution layer, RDL), an under bump metallization (under bump metallization, UBM) structure, a fusion bonding (fusion bonding) structure, and a through silicon via (through silicon via, TSV).

Based on this, it should be understood that, for a chip, an interior of the chip includes a plurality of field effect transistors formed on a substrate by using a front end of line process (front end of line, FEOL), and a plurality of layers of metal wires, a plurality of metal connection pads, a plurality of metal vias, and the like that are formed by using a back end of line process (back end of line, BEOL) after the front end of line process. Metal wires at different layers are connected through metal vias (namely, columnar metals). In the chip, the plurality of transistors on the substrate are connected according to a design requirement by using the plurality of layers of metal wires, to implement specific functions. After the back end of line process, the plurality of metal connection pads are disposed in a top metal (top metal) of the chip. The metal connection pad is connected to the metal wire through the metal via, and the metal connection pad is connected to an external device (for example, another stacked chip) through a connection structure, to implement an electrical connection to the external device. For example, as shown in FIG. 2, the first chip D1 is electrically connected, through a metal connection pad P1 and then through the 3D interconnection structure, to the second chip D2 that is disposed in a stacked manner, and transmits a signal or supplies power to the second chip D2 through the metal connection pad P1.

In comparison with an existing chip that needs to use a same metal connection pad P0 to complete probing and 3D interconnection (with reference to FIG. 1), in the multi-chip stacking package provided in embodiments of this application, at least one chip (for example, the first chip) of a new disposing structure is used, and the chip implements chip probing (chip probing, CP) and 3D interconnection respectively through two different metal pads arranged in parallel. After chip probing is completed, a probe mark on a metal probing pad used for probing is directly removed, and a removal area is filled with a medium material to form a medium filling result. This does not affect an interconnection path, ensures that a signal or a power supply on the interconnection path is not affected, and further avoids problems caused by probe marks generated during chip probing, for example, damage to electrical performance, poor heat dissipation, a limited quantity of stacked layers, and other problems.

The following describes specific disposing of the chip of the new structure used in the multi-chip stacking package provided in embodiments of this application.

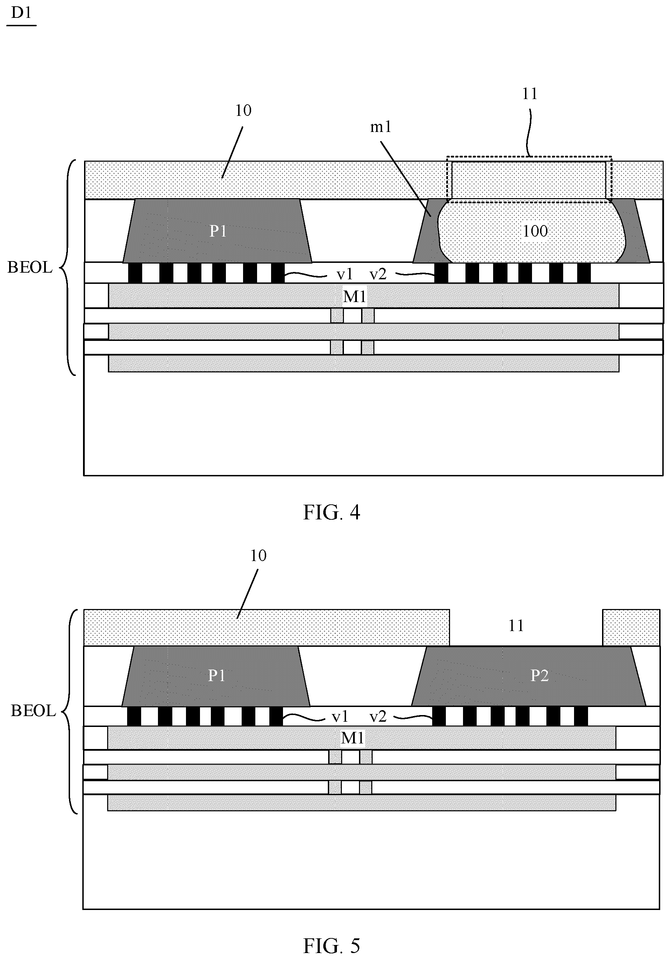

For example, as shown in FIG. 4, an embodiment of this application provides a chip (for example, the first chip D1). The chip includes a metal connection pad P1 and a medium filling structure 100 that is disposed at a same layer as the metal connection pad P1. A first metal wire M1 is disposed below the metal connection pad P1 and the medium filling structure 100. The medium filling structure 100 is formed by filling a medium material.

A plurality of first connection vias v1 are disposed between the metal connection pad P1 and the first metal wire M1, and the metal connection pad P1 is electrically connected to the first metal wire M1 through the plurality of first connection vias v1. A plurality of second connection vias v2 are disposed between the medium filling structure 100 and the first metal wire M1, upper ends of the plurality of second connection vias v2 are connected to the medium filling structure 100, and lower ends of the plurality of second connection vias v2 are electrically connected to the first metal wire M1. The plurality of first connection vias v1 are arranged in parallel, and the plurality of second connection vias v2 are arranged in parallel. In addition, the plurality of first connection vias v1 and the plurality of second connection vias v2 are in an equivalent connection relationship with the first metal wire M1.

Based on this, with reference to FIG. 4, a first medium layer 10 is further disposed on an upper surface of the metal connection pad P1. The first medium layer 10 covers the metal connection pad P1. However, there is a first window 11 (which may also be referred to as a window area) at a position of the medium filling structure 100, and no window needs to be provided at a position of the metal connection pad P1. During chip probing, with reference to FIG. 5, a metal probing pad P2 is disposed at the position of the medium filling structure 100, and the metal probing pad P2 is exposed through the first window 11 for chip probing. After chip probing is completed, a part or all of the metal probing pad P2 is removed through a position of the first window 11, and a removal area is filled with a medium material to form the medium filling structure 100 (for details, refer to a related description below). In other words, there is no complete metal probing pad P2 in a finally formed chip.

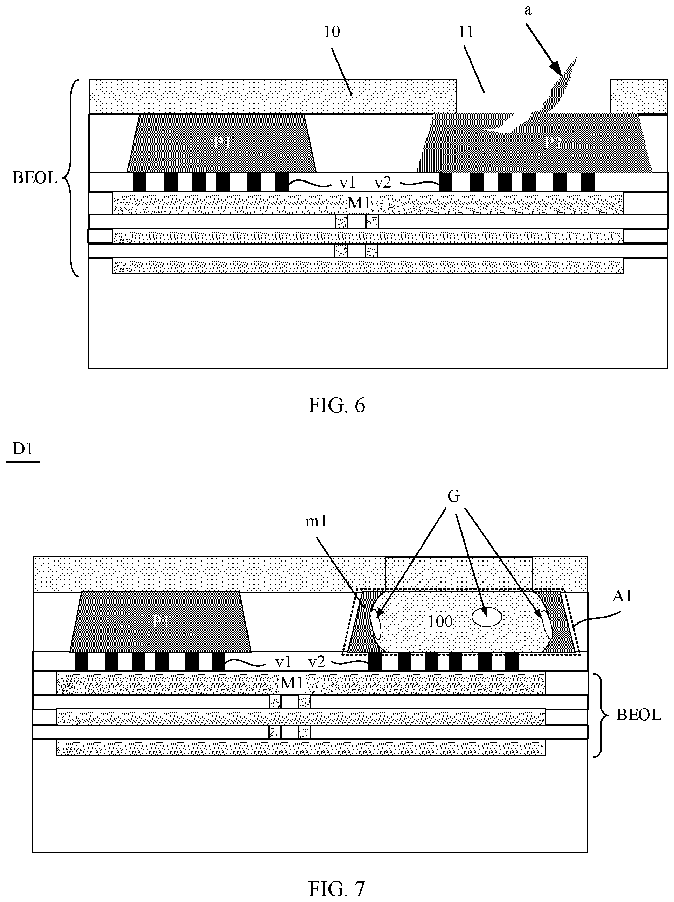

With reference to FIG. 5, the metal probing pad P2 is electrically connected to the first metal wire M1 through the plurality of second connection vias v2, and the metal connection pad P1 and the metal probing pad P2 can form an equivalent electrical connection path, so that chip probing is implemented through the metal probing pad P2, and 3D interconnection between the first chip D1 and the second chip D2 is implemented through the metal connection pad P1. In this case, with reference to FIG. 6, during chip probing, an indentation may be formed and a probe mark a may be generated on a surface of the metal probing pad P2. When the probe mark a is removed through the position of the first window 11, even if the part or all of the metal probing pad P2 is removed, the metal connection pad P1 is not affected.

In other words, in this application, the additionally disposed metal probing pad P2 is used for separately performing chip probing. In this way, after chip probing is completed through the metal probing pad P2, when the probe mark a on the metal probing pad P2 is directly removed, an interconnection path is not affected. This ensures that quality of an electrical signal on the interconnection path is not affected, and avoids a problem of damage to electrical performance of the chip due to chip probing.

In addition, in a conventional technology, a manner of burying the probe mark a by using a thick medium layer causes a large thickness of a stacking interface between chips. This is inconducive to stacking of a plurality of layers of chips, and also brings a heat dissipation problem of stacked chips. In addition, a 3D interconnection structure between chips, a size of a connection pad, and size scale-down (scale down) of a spacing are limited.

In comparison, in this application, the probe mark on the metal probing pad is removed, so that a thickness of a stacking interface between the first chip D1 and the second chip D2 can be reduced. This reduces thermal resistance, optimizes a heat dissipation capability of the chip, and also enables a final form of a stacking structure to bear stacking of more layers of wafers. In addition, this reduces design constraints on the 3D interconnection structure above the metal connection pad P1 and a 2D interconnection structure below the metal connection pad P1, reduces a coupling relationship between 3D interconnection and 2D interconnection, is more conducive to flexible processing of a process and control of mass production quality, and is also more conducive to reducing key sizes of the 3D interconnection structure above the metal connection pad P1 and the 2D interconnection structure below the metal connection pad P1, thereby facilitating further development of a 3D technology.

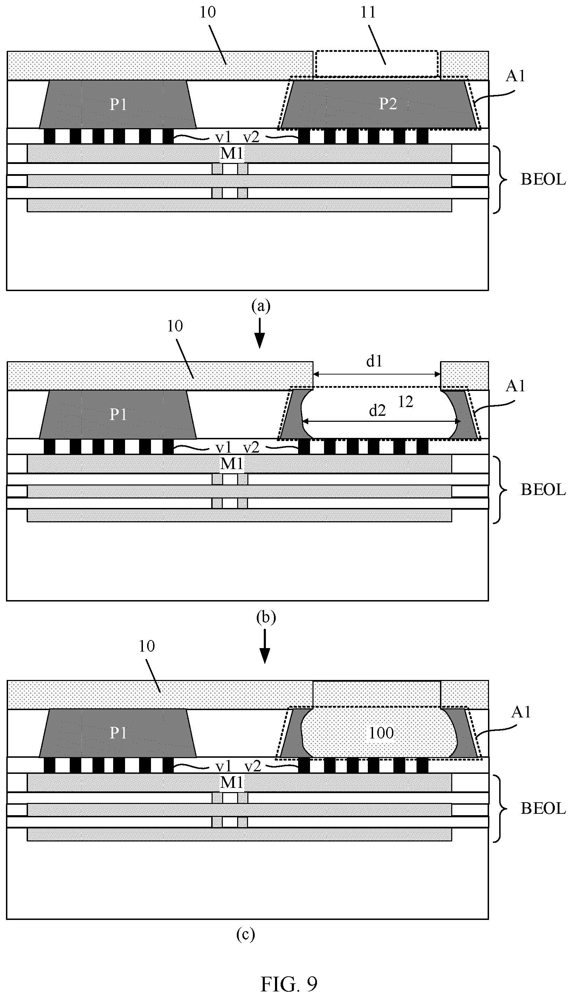

For the finally formed chip, with reference to FIG. 4, in a process of removing the probe mark a, the part or all of the metal probing pad P2 is removed, so that a concave removal area 12 (with reference to FIG. 9) is formed at a position of the metal probing pad P2. A medium material (which may also be referred to as a dielectric material) may be used to fill the removal area 12 to form the medium filling structure 100. For example, in some possible implementations, the medium material for forming the medium filling structure 100 may include one or more of SiO₂, SiN, SiON, SiOC, and a-Si (namely, amorphous silicon).

For the medium filling structure 100, in the process of removing the probe mark a, if the entire metal probing pad P2 is removed, the medium filling structure 100 occupies an entire area in which the metal probing pad P2 is located. If a part of the metal probing pad P2 is removed, with reference to FIG. 4, a part of the metal material (which may also be referred to as a first metal material) remains around the medium filling structure 100.

In some possible implementations, the metal probing pad P2 and the metal connection pad P1 are disposed at a same layer and with a same material. In other words, the metal probing pad P2 and the metal connection pad P1 have the same material, and the two (P1 and P2) may be fabricated by using a same fabricating process. In this case, a residual metal around the medium filling structure 100 is the part of the metal probing pad P2. That is, a material of the residual metal may be the same as a material for forming the metal connection pad P1. For example, metal materials for forming the metal probing pad P2 and the metal connection pad P1 may include one or more of Al, Cu, W, SnCu, and AlCu.

In addition, with reference to FIG. 7, when the removal area 12 (namely, an area in which the metal is removed) formed by removing the metal probing pad P2 is filled with the medium material to form the medium filling structure 100, based on a deposition manner of the medium filling structure 100, a used medium material, and the like (for details, refer to the following), the medium filling structure 100 may not be fully filled, and a void G may be formed in a filling area. A position, a shape, a size, a quantity, and the like of the void G that may be formed in the filling area are not limited in this application. Specifically, the void G may be randomly formed depending on a shape of the filling area, a filling material, and a filling manner.

For example, in some possible implementations, there may be one or more long-strip voids G around the medium filling structure 100. For another example, in some possible implementations, one or more circular or approximately circular (for example, elliptical) voids G may be formed in an interior of the medium filling structure 100. Certainly, in some possible implementations, as shown in FIG. 7, voids G may be formed both at an edge of and in an interior of the medium filling structure 100.

The following further describes the chip with reference to a chip fabricating method.

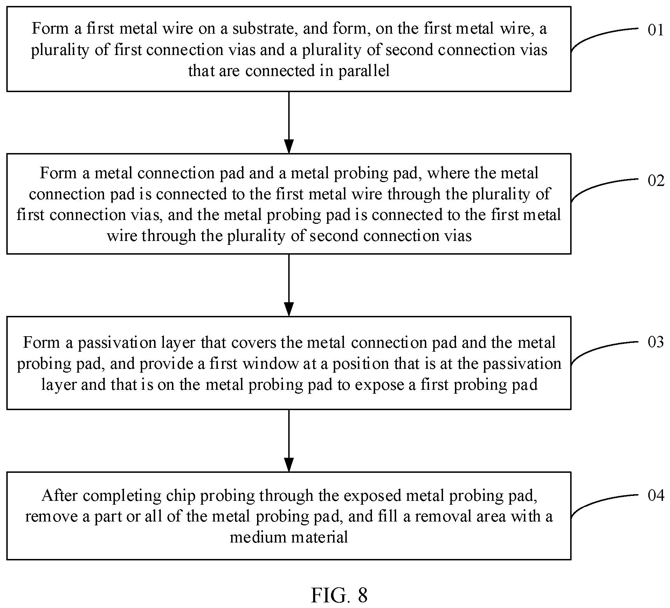

For example, an embodiment of this application provides a chip fabricating method. With reference to FIG. 8, the fabricating method includes the following steps.

Step 01: With reference to (a) in FIG. 9, form a first metal wire M1 on a substrate, and form, on the first metal wire M1, a plurality of first connection vias v1 and a plurality of second connection vias v2 that are arranged in parallel.

For example, in some possible implementations, with reference to (a) in FIG. 9, step 01 may include: provide the substrate, where devices such as a plurality of field-effect transistors (not shown in FIG. 9) that are fabricated by using a front end of line process are disposed on the substrate; fabricate a plurality of layers of metal wires by using a back end of line process, where an uppermost layer of the plurality of layers of metal wires includes the first metal wire M1; and form a medium layer, and forming the plurality of first connection vias v1 and the plurality of second connection vias v2 at the medium layer by using a metal material. For example, one or more conductive materials of Cu, W, Al, SnCu, and AlCu may be used to form the plurality of first connection vias v1 and the plurality of second connection vias v2.

Step 02: With reference to (a) in FIG. 9, form a metal connection pad P1 and a metal probing pad P2, where the metal connection pad P1 is electrically connected to the first metal wire M1 through the plurality of first connection vias v1, and the metal probing pad P2 is electrically connected to the first metal wire M1 through the plurality of second connection vias v2.

For example, in some implementations, with reference to (a) in FIG. 9, step 02 may include: on the substrate on which the plurality of first connection vias v1 and the plurality of second connection vias v2 are formed, by using one or more conductive materials of Al, Cu, W, SnCu, AlCu, and the like, form the metal connection pad P1 at a position corresponding to the plurality of first connection vias v1, and form the metal probing pad P2 at a position corresponding to the plurality of second connection vias v2. In this way, the metal connection pad P1 is electrically connected to the first metal wire M1 through the plurality of first connection vias v1, and the metal probing pad P2 is electrically connected to the first metal wire M1 through the plurality of second connection vias v2, to form the metal connection pad P1 and the metal probing pad P2 that are arranged in parallel. In this way, the metal connection pad P1 and the metal probing pad P2 can form an equivalent electrical connection path, the metal connection pad P1 is used for subsequent 3D interconnection, and the metal probing pad P2 is used for subsequent chip probing.

In addition, barrier layers may be formed between the metal probing pad P1 and the first connection vias v1 and between the metal probing pad P2 and the second connection vias v2. That is, the barrier layers may be formed on surfaces of the first connection vias v1 and the second connection vias v2. The barrier layer may be disposed as an etch stop layer (etch stop layer), to avoid damage to the first connection vias v1 and the second connection vias v2 by a subsequent etching process. For details, refer to step 03 and related descriptions. For example, a material for forming the barrier layer may include one or more metals or metal compounds of Ti, TiN, Ta, TaN, Mn, Co, and the like.

Step 03: With reference to (a) in FIG. 9, form a passivation layer 1 that covers the metal connection pad P1 and the metal probing pad P2, and provide a first window 11 at a position that is at the passivation layer 1 and that is on the metal probing pad P2 to expose the metal probing pad P2.

For example, in some possible implementations, with reference to (a) in FIG. 9, step 03 may include: form the passivation layer 1 that covers the metal connection pad P1 and the metal probing pad P2 by using one or more medium materials of SiO₂, SiN, SiON, SiOC, a-Si, and the like; and provide the first window 11 at the position that is at the passivation layer 1 and that is on the metal probing pad P2 to expose the metal probing pad P2. No window needs to be provided at a position of the metal connection pad P1.

In other words, the passivation layer 1 formed in step 03 covers the metal connection pad P1, and the metal probing pad P2 is exposed at a position of the first window 11. In this way, chip probing may be performed from the first window 11 through the exposed metal probing pad P2, to detect whether the chip is qualified. During chip probing, an indentation may be formed and a probe mark a may be generated on a surface of the metal probing pad P2 (with reference to FIG. 6).

Step 04: With reference to (b) and (c) in FIG. 9, after chip probing is completed through the exposed metal probing pad P2, remove a part or all of the metal probing pad P2, and fill a removal area 12 with a medium material.

For example, in some possible implementations, with reference to (b) in FIG. 9, step 04 may include the following: first, by using a method such as dry etching (dry etch) or wet etching (wet etch), remove the probe mark a that may exist on the surface of the metal probing pad P2 from the position of the first window 11, and remove the part or all of the metal probing pad P2 when the probe mark a is removed. In this case, when a barrier layer exists on the surfaces of the first connection vias v1 and the second connection vias v2, the barrier layer is used as an etch stop layer (etch stop layer) to prevent an ion in dry etching or etching liquid in wet etching from damaging or being in contact with the first connection vias v1 and the second connection vias v2. Then, with reference to (c) in FIG. 9, by using a plasma enhanced chemical vapor deposition (plasma enhanced chemical vapor deposition, PECVD) method, a high density plasma chemical vapor deposition (high density plasma chemical vapor deposition, HDPCVD) method, or a tetraethyl orthosilicate (tetraethyl orthosilicate, TEOS) or atomic layer deposition (Atomic layer deposition, ALD) growth process, fill the removal area 12 with the medium material to form the medium filling structure 100.

A person skilled in the art may understand that, with reference to (b) in FIG. 9, based on a removal process, it may be learned that the removal area 12 (namely, a range in which the metal is removed) formed through the first window 11 may be greater than a range of the first window 11, that is, a maximum horizontal size d2 of the removal area 12 formed through etching is greater than a horizontal size d1 of the first window; and an extended area of the removal area 12 relative to the first window 11 is related to a removal process condition. This is not limited in this application.

For other related parts of step 04, refer to the foregoing descriptions. Details are not described herein again. For example, in step 04, the metal probing pad P2 may be completely removed, or only a part in a central area of the metal probing pad P2 may be removed, and some metals remain around the medium filling structure 100. For example, when the removal area 12 is filled with the medium material to form the medium filling structure 100 in step 04, the medium filling structure 100 may not be fully filled based on a shape of a filling area, a filling material, a filling manner, and the like, and therefore a void G may be formed in the filling area.

In addition, a material for forming the medium filling structure 100 may be the same as or different from a material for forming the passivation layer 1. This is not limited in this application. In practice, the material may be selected and set according to a requirement. For example, the material for forming the medium filling structure 100 may include one or more of SiO₂, SiN, SiON, SiOC, a-Si, and the like.

With reference to (c) in FIG. 9, when the removal area 12 is filled in step 04, a position of the first window 11 provided at the passivation layer 1 may be filled as a whole, and surface processing is performed by using a process such as a chemical mechanical polishing (chemical mechanical polishing, CMP) process to form a flat surface.

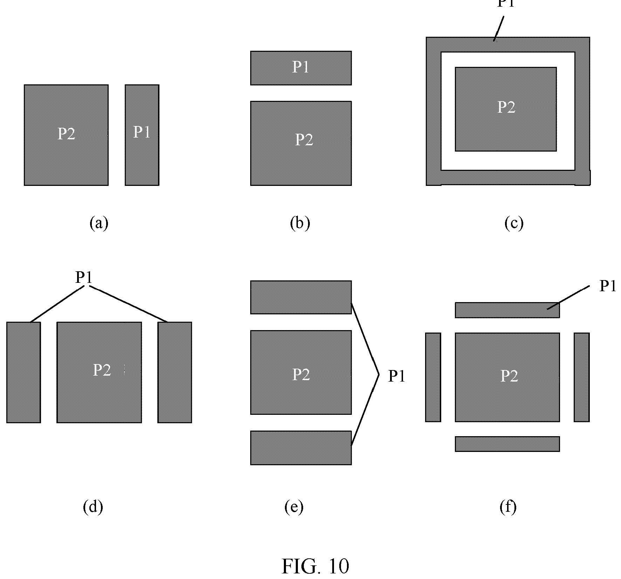

In addition, a manner of connecting the metal connection pad P1 and the metal probing pad P2 in parallel that are formed in step 02 is not limited in this application. In practice, the manner of connecting the metal connection pad P1 and the metal probing pad P2 in parallel may be set according to a scenario requirement. For example, as shown in (a) and (b) in FIG. 10, the metal connection pad P1 and the metal probing pad P2 may be connected in a single-side parallel manner. For another example, as shown in (c), (d), (e), and (f) in FIG. 10, the metal connection pad P1 and the metal probing pad P2 may be connected in a multi-side parallel manner. When the metal connection pad P1 and the metal probing pad P2 are connected in a multi-side parallel manner, as shown in (c) in FIG. 10, the metal probing pad P2 may be a metal pad; and as shown in (d), (e), and (f) in FIG. 10, the metal connection pad P1 may alternatively be a plurality of metal pads or metal wires. In practice, a distribution form of the metal connection pad P1 may be set according to a scenario requirement.

In this embodiment of this application, a group of metal connection pads P1 and metal probing pads P2 that are arranged in parallel in the chip is merely used as an example for description. However, this application is not limited thereto. In practice, a plurality of different groups of metal connection pads P1 and metal probing pads P2 may be separately disposed in the chip for different metal wires according to a requirement.

It should be understood that sequence numbers of the foregoing processes do not mean execution sequences in embodiments of this application. The execution sequences of the processes should be determined based on functions and internal logic of the processes, and should not be construed as any limitation on the implementation processes of embodiments of this application.

In addition, for other related content in the foregoing fabricating method, reference may be made to a corresponding part in the foregoing chip structure embodiment, and details are not described herein again. For another disposing structure in the foregoing chip structure embodiment, reference may be made to the foregoing fabricating method and a related fabricating method for adjustment, and details are not described herein again.

After the chip is fabricated, a 3D interconnection structure may be fabricated on the chip, and the chip may be stacked with another chip. This is not limited in this application, and may be set according to a requirement in practice.

For example, with reference to FIG. 2 and FIG. 3, after the first chip D1 is fabricated, a third via v3 (RDL via) and a redistribution layer RDL may be successively fabricated. The redistribution layer RDL is connected (landing) to the metal connection pad P1 in the first chip D1 through the third via v3, and no connection via is provided at a position of the medium filling structure 100. In this way, interconnection between the redistribution layer RDL and the metal wire M1 inside the first chip D1 is implemented. A 3D connection structure such as a hybrid bonding (hybrid bonding, HB) structure, a direct connection (direct bonding) structure, a µbump (µbump) structure, a fusion bonding (fusion bonding) structure, or a through silicon via TSV may be fabricated at the redistribution layer RDL to interconnect the metal connection pad P1 with the second chip D2, so that a signal or power of the metal connection pad P1 is transmitted or supplied to the second chip D2 through the 3D connection structure in a stacking interface, or an output of the metal connection pad P1 is used as an external pin (PIN) of a stacking package.

In addition, a manner of disposing a connection pad in the second chip D2 is not limited in this application. For example, the second chip D2 may use an existing chip disposing manner, that is, use a same connection pad to complete probing and 3D interconnection. For another example, as shown in FIG. 3, the second chip D2 may alternatively use a chip of a new structure provided in embodiments of this application, that is, use a connection pad and a probing pad that are separately disposed to respectively implement 3D interconnection and chip probing.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A chip, comprising a metal connection pad, a plurality of first connection vias, a plurality of second connection vias, a first metal wire, a medium filling structure, and a first medium layer, wherein
the metal connection pad is electrically connected to the first metal wire through the plurality of first connection vias;
the medium filling structure and the metal connection pad are disposed at a same layer;
the plurality of second connection vias are located between the medium filling structure and the first metal wire, and are electrically connected to the first metal wire; and
the first medium layer covers the metal connection pad, the first medium layer has a window area at a position corresponding to the medium filling structure, and the window area is filled with a dielectric material.

2. The chip according to claim 1, wherein
a first metal material remains around the medium filling structure.

3. The chip according to claim 1, wherein
there is a void in an interior of and/or at an edge of the medium filling structure.

4. The chip according to any one of claims 1 to 3, wherein
the medium filling structure comprises one or more of SiO₂, SiN, SiON, SiOC, and a-Si.

5. The chip according to any one of claims 2 to 4, wherein
the first metal material comprises one or more of Al, Cu, W, SnCu, and AlCu.

6. The chip according to any one of claims 2 to 5, wherein
the first metal material is the same as a material of the metal connection pad.

7. A multi-chip stacking package, comprising a first chip and a second chip that are disposed in a stacked manner, wherein the first chip is the chip according to any one of claims 1 to 6; and
the first chip is electrically connected to the second chip through the metal connection pad, and the medium filling structure is isolated from the second chip through a medium layer.

8. The multi-chip stacking package according to claim 7, wherein
the metal connection pad is connected to the second chip through a first connection structure; and
the first connection structure comprises one or more of a hybrid bonding structure, a redistribution layer, an under bump metallization structure, a fusion bonding structure, and a through silicon via.

9. A chip fabricating method, comprising:
forming a first metal wire on a substrate, and forming a plurality of first connection vias and a plurality of second connection vias on the first metal wire;
forming a metal connection pad and a metal probing pad, wherein the metal connection pad is connected to the first metal wire through the plurality of first connection vias, and the metal probing pad is connected to the first metal wire through the plurality of second connection vias;
forming a passivation layer that covers the metal connection pad and the metal probing pad, and providing a first window at a position that is at the passivation layer and that is on the metal probing pad to expose the metal probing pad; and
after completing chip probing through the exposed metal probing pad, removing a part or all of the metal probing pad, and filling a removal area with a medium material.

10. An electronic device, comprising a circuit board and the chip according to any one of claims 1 to 6, wherein the chip is electrically connected to the circuit board.
